# EUROPEAN PATENT SPECIFICATION

(11) **EP 0 667 058 B1**
(45) Date of publication and mention of the grant of the patent: **03.03.1999**
(21) Application number: 93922564.5
(22) Date of filing: 20.10.1993
(51) Int. Cl.: H03K 5/135, G06F 1/04

(54) **A METHOD AND A DEVICE FOR A CHANGEOVER OF ASYNCHRONOUS CLOCK SIGNALS**
VERFAHREN UND VORRICHTUNG ZUM UMSCHALTEN ASYNCHRONER TAKTSIGNALE
PROCEDE ET DISPOSITIF POUR UNE COMMUTATION DE SIGNAUX D'HORLOGE ASYNCHRONES

(30) Priority: 27.10.1992 FI 924870
(43) Date of publication of application: 16.08.1995
(73) Proprietor: NOKIA TELECOMMUNICATIONS OY, 02150 Espoo (FI)
(72) Inventor: RUUSKANEN, Markku, FIN-06100 Porvoo (FI)
(74) Representative: Tomlinson, Kerry John
(86) International application number: FI9300430
(87) International publication number: WO9410752

(56) References cited:
- EP-A- 0 254 406
- GB-A- 2 181 025
- US-A- 4 748 417
- US-A- 5 155 380
- US-A- 5 197 126
- US-A- 5 231 636

## Description

The invention relates to a method of providing redundancy for an asynchronous clock signal, in which method redundant asynchronous clock signals are changed over for being used as a clock signal by means of a separate selection signal, and where the changeover is performed by setting the outgoing clock signal at the edge of the used clock signal to a constant state and the clock signal to be used is activated to constitute the outgoing clock signal at such an edge of itself which is at least the second in order counted from the moment at which the outgoing clock signal is set to the constant state.

When redundant asynchronous clock signals are used, a random spurious pulse appears in connection with a change of the clock signal to be used, which pulse may cause malfunctions of the device using the clock. Due to these disturbances, transmission errors occur in the traffic to be transmitted in a digital telephone exchange using the changeover, as well as unnecessary alarms in the clock controlling units.

A known method of controlling the change procedure of a clock signal to be used is to generate the clock signal independently and to lock the phase of the generated signal to the phase of a selected reference signal. Implementation of a phase-lock is, however, complicated and, in general, the operation thereof has to be controlled separately.

The object of this invention is to provide a device, by means of which asynchronous clock signals may be changed over in a simple manner without disturbances. Thus according to a first aspect, the invention provides a method of providing redundancy for an asynchronous clock signal, in which method redundant asynchronous clock signals are changed over for being used as a clock signal by means of a separate selection signal, and where the changeover is performed by setting the outgoing clock signal at the edge of the used clock signal to a constant state, and the clock signal to be used is activated to constitute the outgoing clock signal at such an edge of itself which is at least the second in order counted from the moment at which the outgoing clock signal is set to the constant state, characterized in that sample signals are generated from the selection signal at the rising and falling edge of the redundant asynchronous clock signals and that the sample signals are fed back crosswise to the sampling circuits controlled by the clock signals, whereby, at changeover of the clock signal, the outgoing clock signal is set to a constant state by the sample signal corresponding to the used clock signal and that the feedback of the sample signals does not activate the asynchronous clock signal to be used as the outgoing clock signal until the change of state of the sample signal corresponding to the used clock signal has been sampled by the clock signal to be used.

Thus the feedback of the sample signals does not activate the asynchronous clock signal to be used as the outgoing clock signal until the change of state of the sample signal of the used clock signal has been sampled by the clock signal to be used.

According to a second aspect of the invention, there is provided a device for providing redundancy for an asynchronous clock signal, constituted by a changeover switch of redundant asynchronous clock signals, which switch is operated by a separate selection signal, the device comprising means for performing a changeover by setting the outgoing clock signal at the edge of the used clock signal to a constant state and means for activating the clock signal to be used to constitute the outgoing clock signal at such an edge of itself which is at least the second in order counted from the moment at which the outgoing clock signal is set to the constant state, characterized in that for each redundant clock signal there is a sampling circuit including two sequentially switched D-flip-flops, for sampling the selection signal at the rising and falling edge of the respective asynchronous clock signals to generate corresponding sample signals, and that the sample signals are fed back crosswise to the sampling circuits whereby, at a change of state of the selection signal, the outgoing clock signal may be set to a constant state by the sample signal corresponding to the used clock signal, and that the feedback of the sample signals is arranged not to activate the asynchronous clock signal to be used as the outgoing clock signal until the change of state of the sample signal corresponding to the used clock signal has been sampled by the clock signal to be used.

Advantages of the method and device according to the invention are an undisturbed changing over from using one clock signal to using another and a simple method of implementation. The other preferred embodiments of the method and the device according to the invention are characterized in what has been set forth below in the claims.

In the following, the invention will be explained in greater detail by means of an example referring to the attached drawing, in which

Figure 1 shows a switch diagram of a device according to the invention,

Figure 2 shows a timing plan of the invention.

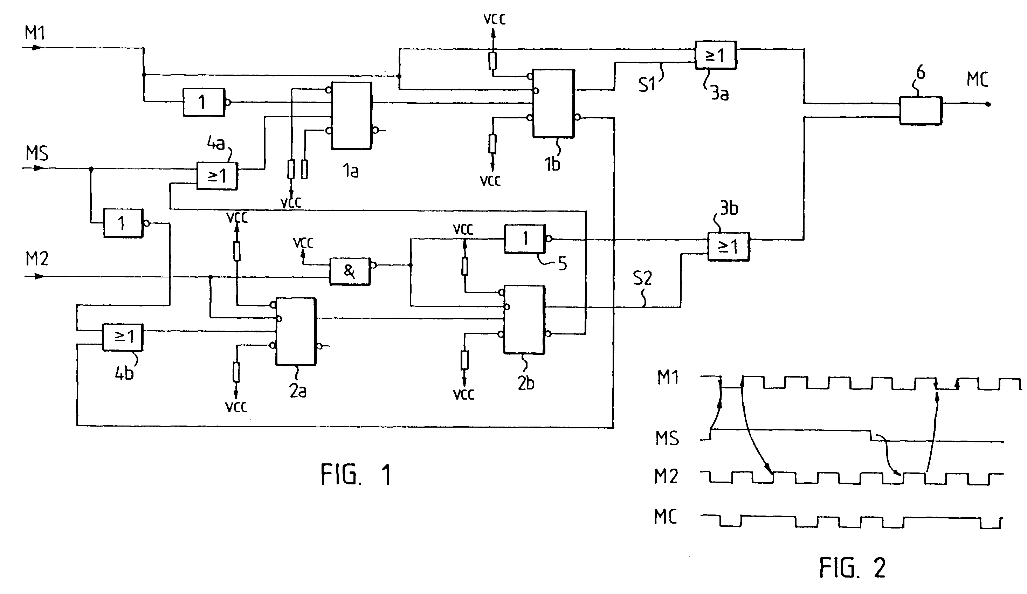

A device for a changeover of clock signals according to the invention is shown in Figure 1. An asynchronous clock selection signal MS and the inversion thereof are sampled by mutually asynchronous clock signals M1 and M2. The samples are taken by two sequentially switched D-flip-flop circuits 1a, 1b and 2a, 2b, respectively, at the rising and falling edge of the clock signals M1 and M2 in order to eliminate an interference peak from sampled selection signals S1 and S2, which are the outputs at pin 5 of the circuit 1b and at pin 9 of the circuit 2b.

The inversion of the selection signal MS is sampled through an OR gate 4b by the clock signal M2, which will be introduced. The inversion of the selection signal S1 sampled by the M1 is led to one input of the OR gate. Thanks to this feedback signal, the selection signal S2 to be obtained from the D-flip-flop 2b changes to zero state and the clock signal M2 will not be introduced until after the used clock signal MC has been stopped in the 1-state. The clock signal M2 will be introduced at the first suitable edge changing to zero state.

According to the invention, two sampled selection signals S1 and S2 are thus generated from the selection signal MS at successive edges of two clock signals. The first sample signal S1 is fed back to the circuit sampling by the second clock signal M2 and the second sample signal S2 is fed back to the circuit sampling by the first clock signal M1. When the second clock signal is introduced, the outgoing clock signal MC is passivated, i.e. left in a constant state by the first selection signal S1. On account of the feedback, the second clock signal M2 cannot be introduced until the change of state of the first sample signal S1 has been sampled by the second clock signal M2.

In the initial situation of the timing plan of Figure 2, the MS is in zero state and the clock signal M1 has been selected to be used as the clock signal MC. With the change of the selection signal MS to the 1-state, the output 5 of the D-flip-flop 1b also changes to the 1-state after the first suitable falling and rising edge of the signal M1. The output of the OR gate 3a and the clock signal MC to be used, selected by the AND circuit 6, also remain in the 1-state. The circuit according to the invention prevents pulse lengths shorter than those of incoming clock signals from occurring in the selected clock signal MC.

When the clock signal M2 is changed over to use, the clock signal MC to be used shows a prolonged pulse in the 1-state. This prolongation depends on the phase difference of the clock signals and is between zero and the duration of one period of the clock signal M2.

When the clock signal M1 is changed over to use, the circuit operates on a corresponding principle. Here, the clock signal MC also shows a prolonged pulse in the 1-state. The length of this prolongation is between the duration of one period of the clock signal M2 and the double value thereof.

A propagation delay of the inverter 5 is longer than the propagation delay of the D-flip-flop 2b. This prevents a spurious pulse at the output (pin 8) of the OR gate 3b when the clock signal M1 is to be used. Without this arrangement, the spurious pulse would occur at a moment when a 1-state is clocked for the first time at the output (pin 9) of circuit 2b.

## Claims

1. A method of providing redundancy for an asynchronous clock signal (MC), in which method redundant asynchronous clock signals (M1,M2) are changed over for being used as a clock signal by means of a separate selection signal (MS), and where the changeover is performed by setting the outgoing clock signal (MC) at the edge of the used clock signal (M1 or M2) to a constant state, and the clock signal to be used (M1 or M2) is activated to constitute the outgoing clock signal (MC) at such an edge of itself which is at least the second in order counted from the moment at which the outgoing clock signal (MC) is set to the constant state, characterized in that sample signals (S1,S2) are generated from the selection signal (MS) at the rising and falling edge of the redundant asynchronous clock signals (M1,M2) and that the sample signals (S1,S2) are fed back crosswise to the sampling circuits controlled by the clock signals (M1,M2), whereby, at changeover of the clock signal, the outgoing clock signal (MC) is set to a constant state by the sample signal corresponding to the used clock signal and that the feedback of the sample signals (S1,S2) does not activate the asynchronous clock signal to be used as the outgoing clock signal (MC) until the change of state of the sample signal corresponding to the used clock signal has been sampled by the clock signal to be used.

2. A device for providing redundancy for an asynchronous clock signal (MC), constituted by a changeover switch of redundant asynchronous clock signals (M1,M2), which switch is operated by a separate selection signal (MS), the device comprising means (1b,2b) for performing a changeover by setting the outgoing clock signal (MC) at the edge of the used clock signal (M1 or M2) to a constant state and means (1a, 1b and 2a, 2b) for activating the clock signal (M1 or M2) to be used to constitute the outgoing clock signal (MC) at such an edge of itself which is at least the second in order counted from the moment at which the outgoing clock signal (MC) is set to the constant state, characterized in that for each redundant clock signal there is a sampling circuit including two sequentially switched D-flip-flops (1a, 1b and 2a, 2b), for sampling the selection signal (MS) at the rising and falling edge of the respective asynchronous clock signals (M1, M2) to generate corresponding sample signals (S1,S2), and that the sample signals (S1,S2) are fed back crosswise to the sampling circuits (1a,2a) whereby, at a change of state of the selection signal (MS), the outgoing clock signal (MC) may be set to a constant state by the sample signal corresponding to the used clock signal, and that the feedback of the sample signals (S1,S2) is arranged not to activate the asynchronous clock signal to be used as the outgoing clock signal (MC) until the change of state of the sample signal corresponding to the used clock signal has been sampled by the clock signal to be used.

## Patentansprüche

1. Verfahren zur Redundanzbereitsteilung für ein asynchrones Taktsignal (MC), wobei bei dem Verfahren zwischen redundanten asynchronen Taktsignalen (M1, M2) zur Verwendung als Taktsignal mittels eines separaten Auswahlsignals (MS) umgeschaltet wird, wobei das Umschalten erfolgt, indem das ausgehende Taktsignal (MC) bei der Flanke des verwendeten Taktsignals (M1 oder M2) auf einen konstanten Pegel gesetzt wird, und wobei das zu verwendende Taktsignal (M1 oder M2) zur Bildung des ausgehenden Taktsignals (MC) bei einer derartigen seiner eigenen Flanken wirksam wird, die zumindest die zweite in der von dem Zeitpunkt an gezählten Reihenfolge ist, bei dem das ausgehende Taktsignal (MC) auf den konstanten Pegel gesetzt wird,
**dadurch gekennzeichnet, daß**
Abtastsignale (S1, S2) von dem Auswahlsignal (MS) bei der steigenden und fallenden Flanke der redundanten asynchronen Taktsignale (M1, M2) erzeugt werden, und
die Abtastsignale (S1, S2) wechselweise zu durch die Taktsignale (M1, M2) gesteuerten Abtastschaltungen zurückgeführt werden, wodurch bei einem Schalten des Taktsignals das ausgehende Taktsignal (MC) durch das dem verwendeten Taktsignal entsprechende Abtastsignal auf einen konstanten Pegel gesetzt wird, und daß die Rückkopplung der Abtastsignale (S1, S2) das als das ausgehende Taktsignal (MC) zu verwendende asynchrone Taktsignal nicht aktiviert, bis die Pegeländerung des dem verwendeten Taktsignal entsprechenden Abtastsignals durch das zu verwendende Taktsignal abgetastet wurde.

2. Vorrichtung zur Redundanzbereitstellung für ein asynchrones Taktsignal (MC), mit einem Umwandlungsschalter für redundante asynchrone Taktsignale (M1, M2), wobei der Schalter durch ein separates Auswahlsignal (MS) betätigt wird, wobei die Vorrichtung Einrichtungen (1a, 1b) zur Durchführung eines Schaltens durch Setzen des ausgehenden Taktsignals (MC) bei einer Flanke des verwendeten Taktsignals (M1 oder M2) auf einen konstanten Pegel und Einrichtungen (1a, 1b und 2a, 2b) zur Aktivierung des Taktsignals (M1 oder M2) umfaßt, das zur Bildung des ausgehenden Taktsignals (MC) bei einer derartigen seiner eigenen Flanken zu verwenden ist, die zumindest die zweite in der von dem Zeitpunkt an gezählten Reihenfolge ist, bei dem das ausgehende Taktsignal (MC) auf den konstanten Pegel gesetzt wird,
**dadurch gekennzeichnet, daß**
es für jedes redundante Taktsignal eine zwei in Reihe geschaltete D-Flip-Flops (1a, 1b und 2a, 2b) aufweisende Abtastschaltung zur Abtastung des Auswahlsignals (MS) bei der steigenden und fallenden Flanke der jeweiligen asynchronen Taktsignale (M1, M2) zur Erzeugung entsprechender Abtastsignale (S1, S2) gibt, und
die Abtastsignale (S1, S2) wechselweise zu den Abtastschaltungen (1a, 2a) zurückgeführt werden, wodurch bei einer Pegeländerung des Auswahlsignals (MS) das ausgehende Taktsignal (MC) durch das dem verwendeten Taktsignal entsprechende Abtastsignal auf einen konstanten Pegel gesetzt werden kann, und daß die Rückkopplung der Abtastsignale (S1, S2) geeignet ist, um das als das ausgehende Taktsignal (MC) zu verwendende asynchrone Taktsignal nicht zu aktivieren, bis die Pegeländerung des dem verwendeten Taktsignal entsprechenden Abtastsignals durch das zu verwendende Taktsignal abgetastet wurde.

## Revendications

1. Procédé pour réaliser une redondance pour un signal d'horloge asynchrone (MC), procédé dans lequel des signaux d'horloge asynchrones redondants (M1, M2) sont inversés pour servir de signal d'horloge à l'aide d'un signal de sélection séparé (MS), et où l'inversion s'effectue en mettant dans un état constant le signal d'horloge de départ (MC) sur le front du signal d'horloge utilisé (M1 ou M2), et le signal d'horloge à utiliser (M1 ou M2) est activé pour constituer le signal d'horloge de départ (MC) sur un front de lui-même qui est au moins le deuxième par ordre en comptant depuis le moment où le signal d'horloge de départ (MC) est mis dans l'état constant, caractérisé en ce que des signaux d'échantillonnage (S1, S2) sont générés à partir du signal de sélection (MS) sur le front montant et descendant des signaux d'horloge asynchrones redondants (M1, M2), en ce que les signaux d'échantillonnage (S1, S2) sont réinjectés transversalement dans les circuits d'échantillonnage commandés par les signaux d'horloge (M1, M2), grâce à quoi, lors de l'inversion du signal d'horloge, le signal d'horloge de départ (MC) est mis dans un état constant par le signal d'échantillonnage correspondant au signal d'horloge utilisé, et en ce que la réinjection des signaux d'échantillonnage (S1, S2) n'active pas le signal d'horloge asynchrone à utiliser comme signal d'horloge de départ (MC) jusqu'à ce que le changement d'état du signal d'échantillonnage correspondant au signal d'horloge utilisé ait été échantillonné par le signal d'horloge à utiliser.

2. Dispositif pour réaliser une redondance pour un signal d'horloge asynchrone (MC), constitué par un inverseur de signaux d'horloge asynchrones redondants (M1, M2), lequel inverseur est actionné par un signal de sélection séparé (MS), le dispositif comportant des moyens (1b, 2b) servant à effectuer une inversion en mettant dans un état constant le signal d'horloge de départ (MC) sur le front du signal d'horloge utilisé (M1 ou M2), et des moyens (1a, 1b et 2a, 2b) servant à activer le signal d'horloge (M1 ou M2) à utiliser pour constituer le signal d'horloge de départ (MC) sur le front de lui-même qui est au moins le deuxième par ordre en comptant depuis le moment où le signal d'horloge de départ (MC) est mis dans l'état constant, caractérisé en ce que, pour chaque signal d'horloge redondant, il y a un circuit d'échantillonnage comportant deux interrupteurs (1a, 1b et 2a, 2b) à bascules du type D à commutation successive, pour échantillonner le signal de sélection (MS) sur le front montant et descendant des signaux d'horloge asynchrones respectifs (M1, M2) afin de générer des signaux d'échantillonnage correspondants (S1, S2), en ce que les signaux d'échantillonnage (S1, S2) sont réinjectés transversalement dans les circuits d'échantillonnage (1a, 2a), grâce à quoi, lors d'une inversion de l'état du signal de sélection (MS), le signal d'horloge de départ (MC) peut être mis dans un état constant par le signal d'échantillonnage correspondant au signal d'horloge utilisé, et en ce que la réinjection des signaux d'échantillonnage (S1, S2) est conçue pour ne pas activer le signal d'horloge asynchrone à utiliser comme signal d'horloge de départ (MC) jusqu'à ce que le changement d'état du signal d'échantillonnage correspondant au signal d'horloge utilisé ait été échantillonné par le signal d'horloge à utiliser.
